# EUROPEAN PATENT APPLICATION

(11) **EP 4 672 301 A1**
(43) Date of publication of application: **31.12.2025**
(21) Application number: 24781023.7
(22) Date of filing: 20.02.2024
(51) Int. Cl.: H01J 37/32

(54) **METHOD AND APPARATUS FOR MONITORING PLASMA STATE AND PLASMA PROCESS STATE**

(30) Priority: 29.03.2023 KR 20230041446
(71) Applicant: Korea Institute of Fusion Energy, Daejeon 34133 (KR)
(72) Inventor: SONG, Jung Ho, Sejong 30092 (KR); CHO, Ki Hwan, Daejeon 34509 (KR)
(74) Representative: Seemann & Partner Patentanwälte mbB
(86) International application number: PCT/KR2024/002155
(87) International publication number: WO 2024/205029

(57) **Abstract**

The present invention relates to a method and an apparatus for monitoring a plasma state and a plasma process state, the method comprising steps in which an electronic device: collects sensing data corresponding to a preset sensing data collection condition from among sensing data acquired from a plurality of sensors; simultaneously stores and pre-processes the sensing data; selects input data for training and is trained; and predicts a plasma state and a plasma process state on the basis of training data derived through the training. Other embodiments are also applicable.

## Description

### [TECHNICAL FIELD]

The present disclosure relates to a method and an apparatus for monitoring a plasma state and a plasma process state.

The present disclosure was derived from the research conducted as part of the Research Operating Cost Support Program of the National Research Council of Science & Technology.
[Project Management Institution] National Research Council of Science & Technology
[Research Program] Research and Operation Cost Support (Main Project Expenses) of the National Research Council of Science & Technology
[Research Project] Development and demonstration of intelligent semiconductor plasma process equipment technology
[Executing Institution] Korea Institute of Fusion Energy
[Research Period] January 1, 2022, to December 31, 2022

### [BACKGROUND ART]

In general, in the manufacturing process of a semiconductor device, plasma equipment that performs etching and deposition of a semiconductor substrate using plasma generated by highfrequency power is widely used. Various sensors are attached to the plasma equipment, and whether the plasma chamber or accessories are operating and their operation states are determined based on sensing data obtained from the sensors.

Currently, sensing data acquired from sensors attached to the plasma chamber are analyzed to determine a start point and an end point of a plasma process, to determine whether there is an abnormality in functions such as the presence or absence of plasma generation, to determine an end point of wafer etching, and to determine whether process by-products generated inside the plasma chamber are removed. However, the accuracy thereof is very low. Accordingly, there are frequent cases where the plasma process stops in the middle of the process, is determined to be operating abnormally even when it is operating normally or is determined to be operating normally even when it is operating abnormally, resulting in a decrease in productivity.

Therefore, when it is desired to change a method for analyzing sensing data to improve the accuracy of monitoring a plasma state or a plasma process state, there arises a problem in that the sensing data have to be reanalyzed for a long time and the verification process for the analysis result has to be performed again. In addition, there is a problem in that the system has to be stopped in order to apply the analysis result.

### [DISCLOSURE]

### [TECHNICAL PROBLEM]

Embodiments of the present disclosure to solve these conventional problems provide a method and an apparatus for monitoring a plasma state and a plasma process state, which perform training by inputting sensing data collected from a plurality of sensors attached to a plasma chamber into machine learning or deep learning, and predict a plasma state and a plasma process state based on a trained result.

Further, embodiments of the present disclosure provide a method and an apparatus for monitoring a plasma state and a plasma process state, which can improve the accuracy of prediction data by comparing sensing data actually collected during a plasma process with prediction data predicted based on a training result.

### [TECHNICAL SOLUTION]

According to an aspect of the present disclosure, there is provided a method for monitoring a plasma state and a plasma process state, the method comprising: collecting, using an electronic device, sensing data corresponding to a preset collection condition among sensing data acquired from a plurality of sensors, simultaneously storing and preprocessing, using the electronic device, the sensing data, selecting, using the electronic device, input data for training and training with the selected input data, and predicting, using the electronic device, a plasma state and a plasma process state based on the training data derived through the training.

In addition, after predicting a plasma state and a plasma process state, the method may further include verifying, using the electronic device, the prediction result, and determining, using the electronic device, whether to stop the plasma process or whether to retrain the sensing data based on the verification result.

In addition, the method further comprises displaying, using the electronic device, at least one of the prediction result and the verification result.

In addition, collecting sensing data includes identifying a collection condition including a name and a unique address of at least one sensor among the plurality of sensors, a number of times for collection failure of the sensing data, and a message name set for the sensing data.

In addition, collecting sensing data includes transmitting a request signal for the sensing data to the at least one sensor in a predetermined period or in real time, and collecting the sensing data from the at least one sensor based on the request signal.

In addition, collecting sensing data includes loading the sensing data into at least one message queue corresponding to the at least one sensor when the collection of the sensing data is completed, and confirming the completion of the collection of the sensing data when loading the sensing data is identified to be completed.

In addition, simultaneous preprocessing includes identifying a preprocessing setting information corresponding to the at least one sensor, and preprocessing the sensing data based on the preprocessing setting information.

In addition, training includes setting a prediction interval for training, selecting sensing data included in the prediction interval among the sensing data loaded into the message queue, performing statistical processing of the selected sensing data, and selecting the input data for training through a regression analysis of the sensing data.

Further, an apparatus for monitoring a plasma state and a plasma process state according to an embodiment of the present disclosure includes a collection module configured to collect sensing data corresponding to a preset collection condition among sensing data related to a plasma process acquired from a plurality of sensors, a data storage module configured to receive and store the sensing data from the collection module, a preprocessing module configured to receive and preprocess the sensing data from the collection module, a training execution module configured to select input data for training among the sensing data preprocessed by the preprocessing module and to train with the selected input data, and a prediction module configured to predict a plasma state and a plasma process state based on the training data derived through the training, wherein the collection module may simultaneously transmit the sensing data to both the data storage module and the preprocessing module.

In addition, the apparatus includes a verification module configured to verify the prediction result predicted by the prediction module and to determine, based on the verification result, whether to stop the plasma process or whether to retrain the sensing data.

In addition, the apparatus includes a visualization module configured to display at least one of the prediction result and the verification result.

In addition, the collection module is configured to identify the collection condition including a name and a unique address of at least one sensor among the plurality of sensors, a number of times for collection failure of the sensing data, and a message name set for the sensing data.

In addition, the collection module is configured to transmit a request signal for the sensing data to the at least one sensor in a predetermined period or in real time, and to collect the sensing data from the at least one sensor based on the request signal.

In addition, the collection module is configured to load the sensing data into at least one message queue corresponding to the at least one sensor when the collection of the sensing data is completed.

In addition, the preprocessing module is configured to identify preprocessing setting information corresponding to the at least one sensor, and to preprocess the sensing data based on the preprocessing setting information.

In addition, the training execution module is configured to set a prediction interval for training, to select sensing data included in the prediction interval among the sensing data loaded into the message queue, and to select the input data for the training through a statistical processing and a regression analysis of the sensing data.

### [ADVANTAGEOUS EFFECTS]

As described above, the method and apparatus for monitoring a plasma state and a plasma process state according to the present disclosure perform training by inputting sensing data collected from a plurality of sensors attached to a plasma chamber into machine learning or deep learning, and predict a plasma state and a plasma process state based on a trained result, thereby providing an effect of being able to monitor the plasma state and the plasma process state.

Further, the method and apparatus for monitoring a plasma state and a plasma process state according to the present disclosure can improve the accuracy of prediction data by reselecting input data for training or performing retraining through comparison of sensing data actually collected during a plasma process with prediction data predicted based on a training result, thereby providing an effect of improving productivity through the plasma process.

### [DESCRIPTION OF DRAWINGS]

FIG. 1 is a diagram illustrating a system for monitoring a plasma state and a plasma process state according to an embodiment of the present disclosure.
FIG. 2 is a flowchart illustrating a method for monitoring a plasma state and a plasma process state according to an embodiment of the present disclosure.
FIG. 3 is a detailed flowchart illustrating a method for collecting sensing data according to an embodiment of the present disclosure.
FIG. 4 is a detailed flowchart illustrating a method for selecting input data according to an embodiment of the present disclosure.
FIG. 5 illustrates a training data table in which training has been completed according to an embodiment of the present disclosure.
FIG. 6 illustrates a prediction data table in which prediction has been completed according to an embodiment of the present disclosure.
7A to 7F are screen examples illustrating visualization data of operation results for monitoring a plasma state and a plasma process state according to an embodiment of the present disclosure.

### [DETAILED DESCRIPTION OF THE EMBODIMENTS]

Hereinafter, preferred embodiments of the present disclosure will be described in detail with reference to the accompanying drawings. The detailed description disclosed below together with the accompanying drawings is intended to explain exemplary embodiments of the present disclosure and is not intended to represent the only embodiments in which the present disclosure can be implemented. In the drawings, parts irrelevant to the description may be omitted for clarity of explanation of the present disclosure, and the same reference numerals may be used for the same or similar components throughout the specification.

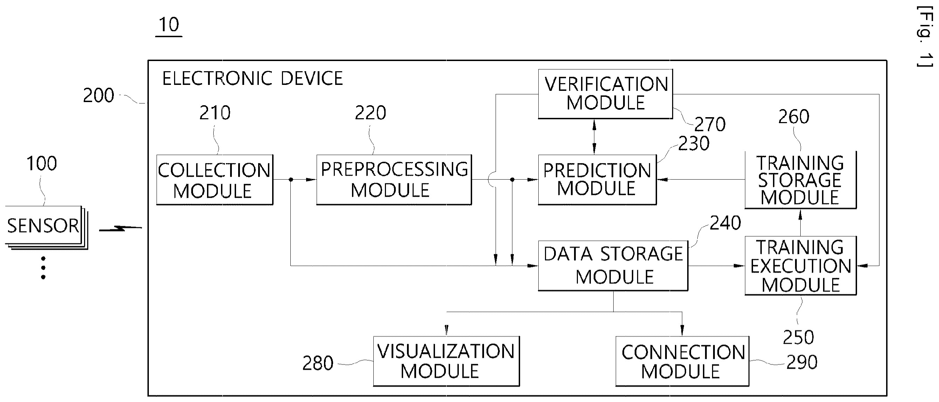

FIG. 1 is a diagram illustrating a system for monitoring a plasma state and a plasma process state according to an embodiment of the present disclosure.

Referring to FIG. 1, a system 10 according to the present disclosure may include a plurality of sensors 100 and an electronic device 200.

The plurality of sensors 100 may include an Optical Emission Spectroscopy (OES) sensor, a Voltage-Current (VI) sensor, and a Mass Flow Controller (MFC) sensor. The plurality of sensors 100 may acquire sensing data such as spectral data related to light generated during a plasma process and electrical characteristic data and provide the sensing data to the collection module 210. To this end, each of the plurality of sensors 100 may communicate with the collection module 210 in a one-to-one manner or may be connected to the collection module 210 in an N-to-one manner through a LAN method.

The electronic device 200 collects sensing data corresponding to a preset collection condition among the sensing data obtained from the plurality of sensors 100 and simultaneously performs storage and preprocessing of the sensing data. The electronic device 200 selects input data for training, trains the selected data, and predicts a plasma state and a plasma process state based on training data derived through the training. To this end, the electronic device 200 may include a collection module 210, a preprocessing module 220, a prediction module 230, a data storage module 240, a training execution module 250, a training storage module 260, a verification module 270, a visualization module 280 and a connection module 290.

The collection module 210 collects sensing data in real time through communication with the plurality of sensors 100 attached to the plasma chamber. To this end, the collection module 210 may perform one-to-one communication with the plurality of sensors 100 or may perform one-to-N communication through a LAN method. The collection module 210 collects the sensing data according to a preset collection condition for collecting the sensing data. More specifically, the collection condition may include a name of each of the plurality of sensors 100, a unique address (e.g., an IP address) for accessing each sensor, a number of times for collection failure and loading failure of the sensing data, and a message name set for the sensing data.

The collection module 210 transmits a request signal for sensing data to each of the sensors 100 periodically or in real time based on the collection condition and collects the sensing data acquired from each sensor 100 according to the request signal. When the number of times of failure to collect the sensing data is equal to or greater than the number of times set in the collection condition, the collection module 210 may determine that an error has occurred in the corresponding sensor. When it is identified that the collection of the sensing data has been completed, the collection module 210 loads the sensing data into a message queue. For example, the collection module 210 may load the sensing data collected from the OES sensor into a message queue named M_OES, may load the sensing data collected from the VI sensor into a message queue named M_VI, and may load the sensing data collected from the MFC sensor into a message queue named M_MFC. When the number of times of failure to load the sensing data into the message queue is equal to or greater than the number of times set in the collection condition, the collection module 210 may determine that an error has occurred in the corresponding message queue.

The collection module 210 may include a message queue program such as RabbitMQ to simultaneously transmit the sensing data to the preprocessing module 220 and the data storage module 240 when it is determined that the sensing data has been completely loaded. In addition, the collection module 210 may generate a thread or a process for collecting the sensing data according to the number of sensors and operate the thread or process for each sensor.

The preprocessing module 220 performs preprocessing such as correction, variation, combination and normalization on the sensing data received from the collection module 210 through the message queue, and transmits the sensing data, after the preprocessing is completed, to the prediction module 230 and the data storage module 240 through the message queue.

More specifically, the preprocessing module 220 determines preprocessing setting information for preprocessing the sensing data and performs preprocessing of the sensing data based on the preprocessing setting information. The preprocessing setting information may include items such as a message name, a missing value processing method, a threshold minimum value, a selection column, a normalization processing method and a data reduction method, and may further include other items.

The preprocessing module 220 retrieves the sensing data having the same name as M_OES among the sensing data loaded into the message queue based on the preprocessing setting information, and processes missing values based on the preprocessing setting information. For example, when the method for processing the missing values of the sensing data having the message name M_OES is set to average, the preprocessing module 220 may process the missing values identified in the sensing data using an average value of the sensing data corresponding to the same plasma state and plasma process state. In addition, when the method for processing the missing values of the sensing data having the message name M_MFC is set to deletion, the preprocessing module 220 may delete the missing values identified in the sensing data.

The preprocessing module 220 sets all sensing data lower than the threshold minimum value to the threshold minimum value based on the threshold minimum value specified in the preprocessing setting information. In this case, the threshold minimum value is set to remove outliers of the sensing data.

The preprocessing module 220 selects only the sensing data corresponding to the selection column (item) set in the preprocessing setting information, so as to remove data that is not correlated with or related to the plasma state and the plasma process state.

Subsequently, the preprocessing module 220 performs normalization of the sensing data according to the normalization processing method set in the preprocessing setting information. For example, when the normalization processing method for the sensing data having the message name M_VI is set to a Min/Max method, the preprocessing module 220 performs normalization of the sensing data for M_VI using the Min/Max method.

The preprocessing module 220 performs data reduction of the sensing data based on the data reduction method set in the preprocessing setting information. The preprocessing module 220 transmits the sensing data, after the preprocessing is completed, to the prediction module 230 and the data storage module 240 through the message queue.

The prediction module 230 predicts a plasma state and a plasma process state based on the training results stored in the training storage module 260 and the sensing data transmitted from the preprocessing module 220, and transmits the prediction data to the data storage module 240 and the verification module 270 through the message queue.

More specifically, the prediction module 230 may select at least one training result from among the training results according to a condition determined by the user, for example, a training accuracy or a prediction execution time. The prediction module 230 may input the sensing data transmitted from the preprocessing module 220 into training information to predict a plasma state and a plasma process state. At this time, the prediction module 230 may select a plurality of training items such as an electron density, an electron temperature and a deposition thickness. For example, the prediction module 230 may select an MLR_OES_1 algorithm to predict the electron density, an MLR_VI_1 algorithm to predict the electron temperature, and an XB_OES_VI_MFC_1 algorithm to predict the deposition thickness. In this case, the prediction module 230 performs the prediction by using the sensing data of OES, VI and MFC.

When the prediction of the electron density, the electron temperature and the deposition thickness is completed, the prediction module 230 stores a prediction data table in the data storage module 240. In this case, the prediction data table may include items such as a prediction time, whether a process is in progress, an algorithm name used for prediction, a state value type, a prediction result and an actual measurement value.

The data storage module 240 stores, in real time, data transmitted through a message queue by the collection module 210, the preprocessing module 220, the prediction module 230 and the verification module 270. The data storage module 240 may use a NoSQL system for big data storage to store various data formats and types, and the data stored together with time information may be used as a reference point for data synchronization and visualization.

The data storage module 240 stores sensing data. Since the sensing data collected through the collection module 210 has different types and formats depending on the sensing data acquired from each of the plurality of sensors 100, the sensing data may be stored using a NoSQL database system such as MongoDB. In the present disclosure, in order to store data in real time without loss, an example will be described in which the data is not stored by directly accessing the database but is stored using a message queue. For example, among the sensing data collected through the collection module 210, the OES sensing data acquired from the OES sensor may be loaded into a message queue under the name M_OES.

When there is no prediction data for predicting a plasma state and a plasma process state, the training execution module 250 retrieves the sensing data, after the preprocessing is completed, from the data storage module 240. The training execution module 250 inputs the retrieved sensing data into a training algorithm, repeatedly performs training to accurately predict the plasma state and the plasma process state, and derives a result value.

More specifically, the training execution module 250 may set a prediction interval to predict a plasma state and a plasma process state. For example, when the operation range of semiconductor/display equipment is a plasma electron density of 3 × 10⁸ cm⁻³ to 5 × 10⁹ cm⁻³ and a plasma electron temperature of 2 eV to 7 eV, an electron density of 8 × 10⁸ cm⁻³ to 3 × 10⁹ cm⁻³ and an electron temperature of 3 eV to 6 eV may be set as a range of the prediction interval.

The training execution module 250 selects sensing data included in the set prediction interval and performs statistical processing of the selected sensing data. The training execution module 250 obtains statistical information of the individual items of the selected sensing data, such as a minimum value, a maximum value, a median value, an average value, a standard deviation, a kurtosis and a skewness.

The training execution module 250 performs correlation analysis between all sensing data items or selected sensing data items and a plasma state or a plasma process state to be predicted. The training execution module 250 may predict a plasma state or a plasma process state by inputting all sensing data items or selected sensing data items into a multiple linear regression algorithm. Through the regression analysis, the training execution module 250 may obtain significance probability (p-value), transformation coefficient (weight value) and F-test value information.

The training execution module 250 may select sensing data to be applied as input data to a training algorithm. In this case, the input data may be data selected by determining importance through a basic regression analysis process or may be data selected by analyzing logs and information generated during the training process.

The training execution module 250 performs training by applying the selected input data to a training algorithm. More specifically, the training execution module 250 may identify a form of a plasma state and a plasma process state to select a training algorithm. For example, the training execution module 250 may select various training algorithms according to the number of result values to be predicted (e.g., a case where electron density and electron temperature are predicted individually, or a case where electron density and electron temperature are predicted simultaneously), or according to a form of a result value (e.g., a numerical form or a classification form such as normal/abnormal). At this time, the training execution module 250 may select at least one training algorithm from among algorithms related to supervised learning, unsupervised learning and reinforcement learning, and when a plurality of training algorithms are selected, the plurality of training algorithms may be merged.

The training execution module 250 applies input data and result values to the selected algorithm to perform training. In this case, the training execution module 250 may adjust parameters such as the number of training iterations, the sensing data load size and the number of layers to improve training accuracy. In addition, the training execution module 250 may input test data into the training algorithm to check prediction accuracy and prediction time and may use only training results that satisfy the accuracy and response time set by the user of the electronic device 200. In this case, the training execution module 250 may set one or more training results corresponding to the accuracy and response time set by the user. Through this, the training execution module 250 may select the training algorithm having the highest accuracy by continuously logging the prediction values generated while training is repeated.

The training execution module 250 stores training results in the training storage module 260. The training results stored in the training storage module 260 may include a prediction item, an algorithm name, an input data name, an algorithm used for training, a number of training iterations, a number of training layers, a number of combined training models, a capacity of the training algorithm, a training accuracy and a prediction execution time.

The training storage module 260 stores a result value received from the training execution module 250. In this case, the result value may be stored using a storage method provided by machine learning or deep learning frameworks such as TensorFlow, PyTorch and Keras, or only separately extracted information may be stored.

The verification module 270 compares an actual measurement result obtained in a testing process performed after the actual plasma process is completed with prediction data for the plasma state and a plasma process state predicted by the prediction module 230. To this end, the verification module 270 determines pre-stored verification setting information, and when an error between the prediction data and the actual measurement result is out of a tolerance range included in the verification setting information and the number of errors out of the tolerance range exceeds a number of tolerances included in the verification setting information, the verification module 270 determines whether at least one of process stop or retraining is required.

The visualization module 280 displays sensing data stored in the data storage module 240, sensing data after preprocessing is completed, a plasma state and a plasma process state predicted from the sensing data, a training algorithm used for prediction, and training results of the sensing data. The visualization module 280 may select a form for visualization such as a graph or a table, and may display changes in data over time.

The connection module 290 performs connection with a central server (not illustrated) and a plurality of electronic devices (not illustrated) located outside the electronic device 200. To this end, the present disclosure may implement one central server and a plurality of electronic devices in an edge computing environment. Further, the connection module 290 may transmit measurement information (e.g., wafer thickness information, etching results and normal/defective determination results) measured by the electronic device 200, and a plasma state and a plasma process state predicted by the electronic device 200, to the central server or the plurality of electronic devices.

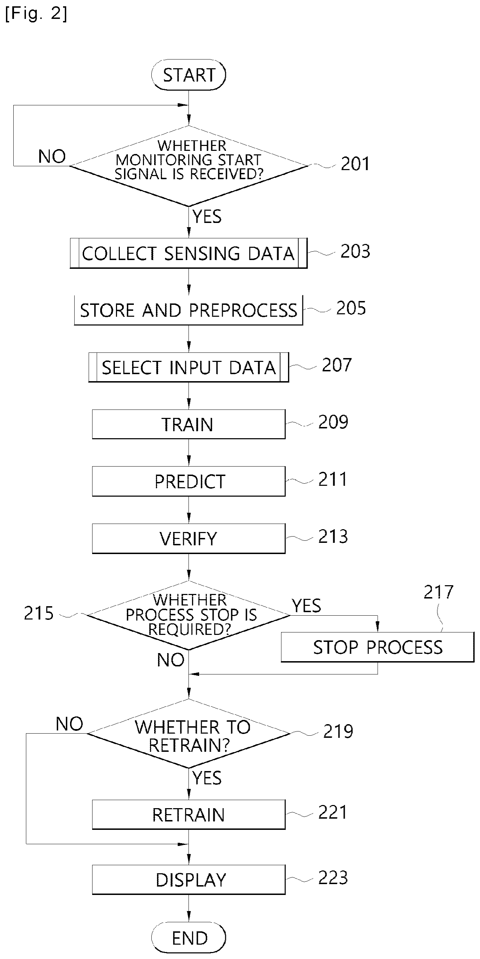

FIG. 2 is a flowchart illustrating a method for monitoring a plasma state and a plasma process state according to an embodiment of the present disclosure.

Referring to FIG. 2, in operation S201, the electronic device 200 checks whether a monitoring start signal for monitoring a plasma state and a plasma process state is received. The monitoring start signal may be received from a user of the electronic device 200 after the plasma process is started. As a result of the checking in operation S201, when the monitoring start signal is received, the electronic device 200 performs operation S203, and when the monitoring start signal is not received, the electronic device 200 waits to receive the monitoring start signal.

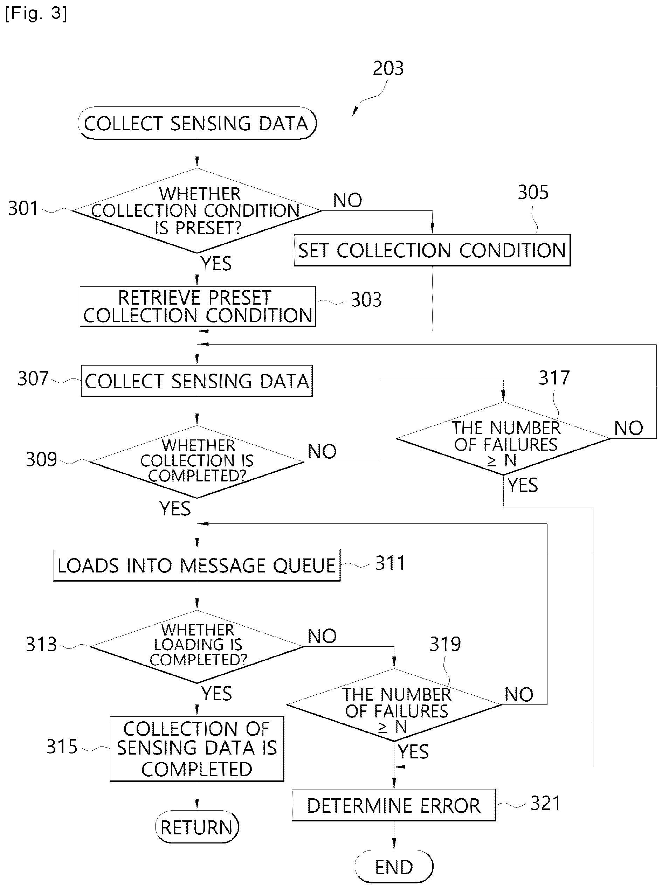

In operation S203, a collection module 210 collects sensing data obtained from a plurality of sensors 100 and performs operation S205. In this case, the method for collecting the sensing data will be described in more detail with reference to FIG. 3. In addition, the plurality of sensors 100 may include an OES sensor, a VI sensor, and an MFC sensor. FIG. 3 is a detailed flowchart illustrating a method for collecting sensing data according to an embodiment of the present disclosure.

Referring to FIG. 3, in operation S301, the collection module 210 performs operation S303 when a collection condition for collecting the sensing data is preset and performs operation S305 when the collection condition is not preset. In operation S305, the collection module 210 may set a collection condition for collecting the sensing data obtained by the sensors 100 by a user of the electronic device 200 and perform operation S307. In addition, in operation S303, the collection module 210 may retrieve a preset collection condition and perform operation S307.

In operation S307, the collection module 210 performs collection of sensing data based on the set collection condition. More specifically, the collection condition may include a name of each of the plurality of sensors 100, a unique address (e.g., an IP address) for accessing each sensor, a number of times for collection failure and loading failure of the sensing data, and a message name set for the sensing data, which may be represented as shown in Table 1 below. In addition, other items may be added to the collection condition in addition to the sensor name, the unique address, the number of failures, and the message name.

**[Table 1]**

| Sensor name | Unique address | Number of failures | Message name |
|---|---|---|---|
| OES | 192.168.0.2 | 3 | M_OES |
| VI | 192.168.0.3 | 3 | M VI |
| MFC | 192.168.0.4 | 5 | M_MFC |

In operation S307, the collection module 210 transmits a request signal for sensing data to each sensor 100 at predetermined intervals or in real time, and collects the sensing data from each sensor 100 according to the request signal. In operation S309, when the collection module 210 identifies that the collection of the sensing data is completed, the collection module 210 performs operation S311, and when the collection module 210 identifies that the collection is not completed, the collection module 210 performs operation S317. Here, when the number of times of failure to collect the sensing data is equal to or greater than the number of failures set in the collection condition, the collection module 210 performs operation S321, and when the number of times of failure is less than the number of failures set in the collection condition, the collection module 210 continues to perform operation S307 to collect the sensing data. For example, when the number of times of failure to collect the sensing data from an OES sensor is equal to or greater than three times, the collection module 210 performs operation S321 and may determine that an error has occurred in the OES sensor.

On the contrary, when the number of times of failure to collect the sensing data from the OES sensor is less than three times, the collection module 210 may perform operation S307 again to continue collecting the sensing data. In operation S311, the collection module 210 loads the sensing data into a message queue. For example, the collection module 210 may load the sensing data collected from the OES sensor into a message queue named M_OES, the sensing data collected from the VI sensor into a message queue named M_VI, and the sensing data collected from the MFC sensor into a message queue named M_MFC.

In operation S313, the collection module 210 performs operation S319 when the loading of the sensing data is not completed. In operation S319, when the number of failures to load the sensing data into the message queue is equal to or greater than the number of failures specified in the collection condition, the collection module 210 performs operation S321, and when the number of failures is less than the number of failures specified in the collection condition, the collection module 210 performs operation S311 to continue loading the sensing data. For example, when the number of failures to load the sensing data acquired from an OES sensor into the message queue named M_OES is equal to or greater than three times, the collection module 210 performs operation S321 and may determine that an error has occurred in the message queue M_OES.

In operation S313, when the collection module 210 identifies that the loading of the sensing data is completed, the collection module 210 performs operation S315 to confirm that the collection of the sensing data has been completed. As described above, when the collection of the sensing data is confirmed to be completed, the electronic device 200 may return to operation S205 of FIG. 2, and a message queue program such as RabbitMQ may be installed so as to simultaneously transmit the collected sensing data to the preprocessing module 220 and the data storage module 240.

More specifically, the preprocessing module 220 retrieves preprocessing setting information for preprocessing the sensing data and performs preprocessing of the sensing data based on the preprocessing setting information. The preprocessing setting information is shown in Table 2 below. In addition, the items of the preprocessing setting information may include items such as a message name, a missing value processing method, a threshold minimum value, a selection column, a normalization processing method and a data reduction method, and may further include other items.

In this case, the training execution module 250 sorts items of the sensing data in the order of standard deviation values based on the results of the statistical processing of the sensing data, and selects 10 sensing data items having a high transformation coefficient (weight value) and a significance probability (p-value) of 0.05 or less acquired through regression analysis as selection columns (items). When the analyzed correlation value is 80% or more, the training execution module 250 may set the data reduction method to "PCA". Through this, the preprocessing setting information may be set. In addition, the preprocessing setting information generated in the above-described method may be reset when training is not properly performed in the training execution module 250, when the accuracy of training is low, or when errors continuously occur in the verification module 270 and retraining should be performed. That is, the preprocessing setting information may be reset when training is performed or when verification is performed.

**[Table 2]**

| Message name | Missing value processing method | Threshold minimum value | Selection column (item) | Normal-ization processing method | Data reduction method |
|---|---|---|---|---|---|
| M_OES | Average | 500 | - | - | PCA |
| M_VI | Identical to the immediately preceding value | -30 | 1,3,5,7,10 | Min/Max | Min/Max |
| M_MFC | Deletion | 0.2 | ALL | STD | STD |

The preprocessing module 220 retrieves, based on the preprocessing setting information, the sensing data named M_OES from among the sensing data loaded into the message queue and processes missing values based on the preprocessing setting information. That is, since the missing value processing method for the sensing data named M_OES is set to average, when missing values are identified, the preprocessing module 220 replaces them with the average of sensing data corresponding to the same plasma state and plasma process state. Meanwhile, missing values identified in the sensing data named M_MFC may be deleted. The preprocessing module 220 sets all sensing data values lower than a preset threshold minimum value to the threshold minimum value, based on the threshold minimum value specified in the preprocessing setting information. In this case, the threshold minimum value is configured to remove outliers from the sensing data. The preprocessing module 220 selects only the sensing data corresponding to the selection columns (items) specified in the preprocessing setting information, in order to remove data that has no correlation or relevance to the plasma state or plasma process state.

Subsequently, the preprocessing module 220 performs normalization of the sensing data according to the normalization processing method set in the preprocessing setting information. For example, since the normalization processing method for the sensing data named M_VI is the Min/Max method, the sensing data for M_VI is normalized using the Min/Max method. That is, when the value of the first item of the sensing data named M_VI is distributed between 900 and 1000 and the value of the second item is distributed between 0 and 10, the second item significantly affects the plasma state and plasma process state. However, because the variation in the first item is greater than that in the second item during training, if training is performed with the first item having greater influence, the training may be degraded and the accuracy may decrease. Therefore, to ensure that both the first and second items have equal influence during machine learning or deep learning, normalization as described above is used to adjust the magnitude of the sensing data item values to the same scale.

The preprocessing module 220 performs data reduction on the sensing data based on a data reduction method set in the preprocessing setting information. In general, using all the sensing data may lead to a problem in which the training is not properly performed, and the accuracy of prediction values based on the training results is degraded. In addition, since the amount of sensing data is enormous, excessive resources may be consumed during training. To address these issues, the preprocessing module 220 may perform data reduction. The preprocessing module 220 transmits the preprocessed sensing data to the prediction module 230 and the data storage module 240 through a message queue.

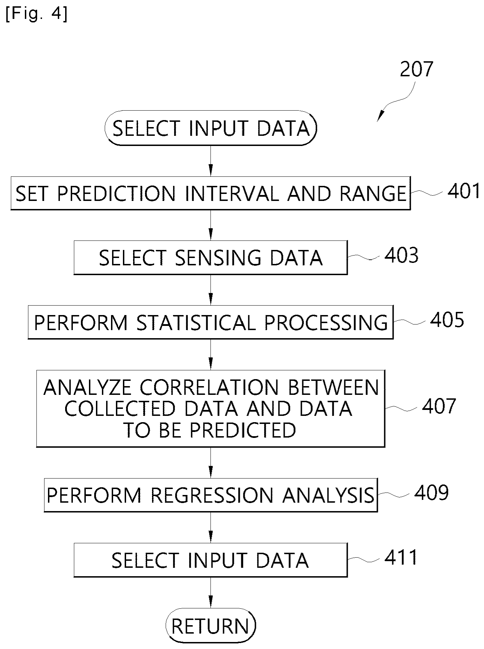

Subsequently, the sensing data transmitted to the data storage module 240 in step 207 is transferred to the training execution module 250, and the training execution module 250 selects input data to perform training. This process will be described in more detail with reference to FIG. 4. FIG. 4 is a detailed flowchart illustrating a method for selecting input data according to an embodiment of the present disclosure.

Referring to FIG. 4, in step 401, the training execution module 250 may set a prediction interval to predict the plasma state and the plasma process state. For example, when the operation range of semiconductor/display equipment is a plasma electron density of 3 × 10⁸ cm⁻³ to 5 × 10⁹ cm⁻³ and a plasma electron temperature of 2 eV to 7 eV, an electron density of 8 × 10⁸ cm⁻³ to 3 × 10⁹ cm⁻³ and an electron temperature of 3 eV to 6 eV may be set as a range of the prediction interval.

In operation S403, the training performing module 250 may select sensing data included in the prediction interval set in operation S401. For example, when it is confirmed that the variation of the sensing data for M_OES and M_MFC is greater than that of the sensing data for M_VI among the sensing data stored in the data storage module 240, the training performing module 250 may select the sensing data for M_OES and M_MFC. For instance, when the plasma electron density changes between 3 × 10⁸ cm⁻³ and 5 × 10⁹ cm⁻³, the sensing data for M_OES, M_MFC, and M_VI may be checked. As a result, it may be confirmed that the sensing data for M_OES changes from 1,000 to 1,200, the sensing data for M_MFC changes from 10 to 15, and the sensing data for M_VI changes from 1.5 to 1.7. Accordingly, the training performing module 250 may select the sensing data for M_OES and M_MFC.

In step 405, the training execution module 250 performs statistical processing of the selected sensing data. More specifically, the training execution module 250 acquires statistical information such as a minimum value, a maximum value, a median value, an average value, a standard deviation, a kurtosis, and a skewness for each item of the selected sensing data. In this case, each item may refer to a value included in the sensing data. For example, in the case of the sensing data acquired from an OES sensor, which typically includes 3,600 wavelengths and corresponding intensity values, each item may refer to the intensity value of each wavelength. In addition, in the case of the sensing data acquired from a VI sensor, each item may refer to data for 15 harmonic components and corresponding voltage, current, and phase values.

In operation S407, the training execution module 250 performs correlation analysis by analyzing the correlation between all sensing data items or selected sensing data items and a plasma state or a plasma process state to be predicted.

In operation S409, the training execution module 250 may predict the plasma state or the plasma process state by inputting all the sensing data items or the selected sensing data items into a multiple linear regression algorithm. Through the regression analysis, the training execution module 250 may acquire information such as a significance probability (p-value), a transformation coefficient (weight value), and an F-test value.

In operation S411, the training execution module 250 selects sensing data to be used as input data for a training algorithm and returns to operation S209 of FIG. 2.

In operation S209, the training execution module 250 performs training by applying the input data selected in FIG. 4 to a training algorithm. More specifically, the training execution module 250 may identify the type of the plasma state and the plasma process state to select a training algorithm. For example, when the plasma state or plasma process state has a fixed value, or when it is a classification such as normal or failure, the training algorithm used for training may vary. In addition, when two or more values are to be predicted simultaneously, the training algorithm used for training may also vary.

Accordingly, the training execution module 250 identifies the form of a result value to be predicted and selects a machine learning or deep learning algorithm (hereinafter referred to as a training algorithm). The training execution module 250 may select at least one training algorithm from among algorithms related to supervised learning, unsupervised learning, and reinforcement learning, and when a plurality of training algorithms are selected, the plurality of training algorithms may be merged.

The training execution module 250 performs training by applying input data and result values to the selected algorithm. In this case, the training execution module 250 may adjust the number of training iterations, the sensing data load size, the number of layers, and the like to improve training accuracy. In addition, the training execution module 250 may provide a function of searching for a setting value that derives the best result value by repeatedly inputting a value of an interval set within a predetermined range. In this case, the value of the interval set within the predetermined range may refer to a value set through a GridSearchCV technique for searching for a training condition capable of most accurately predicting a result value for training.

In addition, the training execution module 250 may input test data into the training algorithm to check prediction accuracy and prediction time and may use only training results that satisfy the accuracy and response time set by the user of the electronic device 200. In this case, the training execution module 250 may set one or more training results corresponding to the accuracy and response time set by the user. Through this, the training execution module 250 may select the training algorithm having the highest accuracy by continuously logging the prediction values generated as training is repeated.

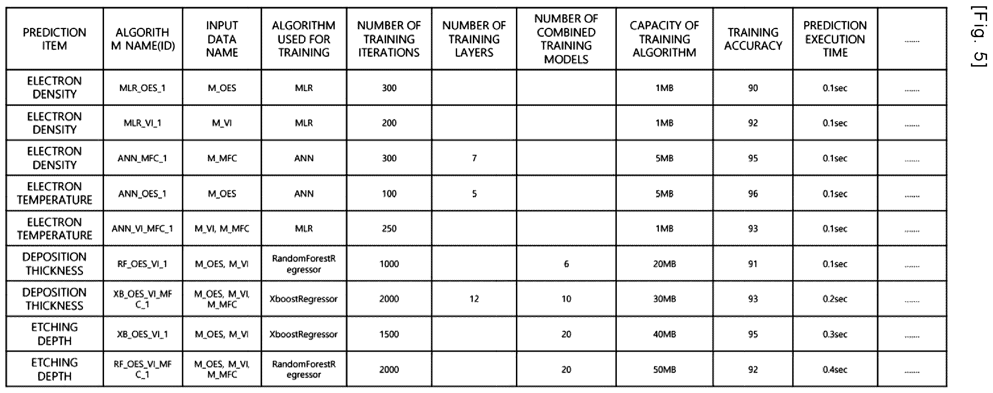

The training execution module 250 may store training results in the training storage module 260 as illustrated in FIG. 5. FIG. 5 illustrates a training data table in which training has been completed according to an embodiment of the present disclosure. Referring to FIG. 5, the training results stored in the training storage module 260 may include a prediction item, an algorithm name, an input data name, an algorithm used for training, a number of training iterations, a number of training layers, a number of combined training models, a capacity of the training algorithm, a training accuracy, and a prediction execution time.

In operation S211, the prediction module 230 performs prediction based on the training results stored in the training storage module 260 and the sensing data transmitted to the preprocessing module 220 after preprocessing is completed in operation S205. More specifically, the prediction module 230 may select at least one training result from among the training results according to a condition determined by the user, for example, a training accuracy or a prediction execution time.

In addition, the prediction module 230 inputs the sensing data transmitted from the preprocessing module 220 into training information to perform prediction of a plasma state and a plasma process state. At this time, the prediction module 230 may select a plurality of training information such as an electron density, an electron temperature, and a deposition thickness. For example, among the training information illustrated in FIG. 5, when an MLR_OES_1 algorithm is selected to predict the electron density, an MLR_VI_1 algorithm is selected to predict the electron temperature, and an XB_OES_VI_MFC_1 algorithm is selected to predict the deposition thickness, the prediction is performed using the total sensing data of OES, VI, and MFC.

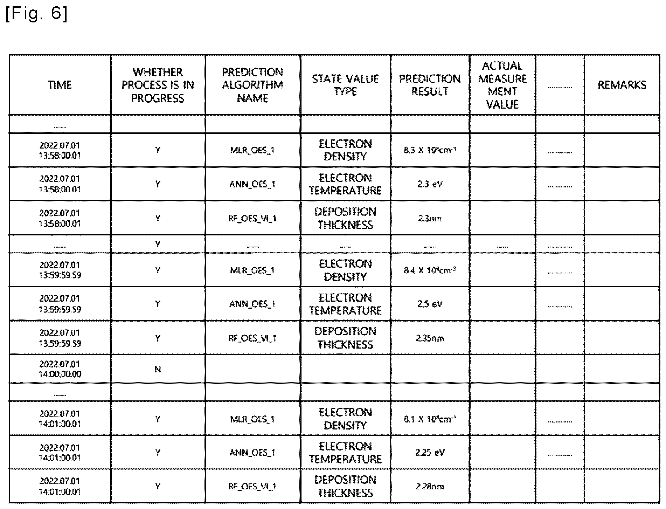

When the prediction of the electron density, the electron temperature, and the deposition thickness is completed, the prediction module 230 stores a prediction data table in the data storage module 240 as illustrated in FIG. 6. FIG. 6 illustrates a prediction data table in which prediction has been completed according to an embodiment of the present disclosure.

Referring to FIG. 6, the prediction data table may include items such as a prediction time, whether a process is in progress, an algorithm name used for prediction, a state value type, a prediction result, and an actual measurement value.

Next, in operation S213, the verification module 270 compares the actual measurement result obtained in the testing process performed after the actual plasma process is completed with the prediction data predicted by the prediction module 230 and performs verification on the prediction data. For example, as illustrated in FIG. 6, when a wafer having a process progressed from 13:58:00 to 13:59:59 of July 01, 2022, is tested, and the deposition thickness is 2.38 nm, 2.38 nm is input as the actual measurement value of the item having the time of 13:59:59 of July 01, 2022, in FIG. 6.

The verification module 270 may check pre-stored verification setting information as shown in Table 3 below, and the verification setting information may be input by the user and stored and may be changed by the user.

**[Table 3]**

| Prediction item | Tolerance | Number of tolerances | Number of errors | Whether to retrain | Whether to stop process |
|---|---|---|---|---|---|
| Electron density | 1 × 10⁹cm⁻¹ | 10 | 2 | Y | N |
| Electron temperature | 0.3eV | 5 | 1 | Y | N |
| Deposition thickness | 0.3nm | 5 | 2 | Y | Y |
| Etching depth | 0.2nm | 3 | 0 | Y | Y |
| ... | ... | ... | ... | ... | ... |

The verification module 270 periodically or in real time compares the prediction data stored in the data storage module 240 in operation S211 with the actual measurement result. In operation S215, the verification module 270 checks whether a process stop is required when, as a result of the comparison, the error between the prediction data and the actual measurement result is out of the tolerance range included in the verification setting information and the number of errors out of the tolerance range exceeds the number of tolerances included in the verification setting information. For example, the verification module 270 checks whether the process is to be stopped when the allowable error of the electron density is 10 times or more and 1×10⁹ cm⁻¹ or more. Referring to Table 3, in the case of the electron density, since the process stop is set to N, the verification module 270 performs operation S219. In operation S219, since the retraining of the electron density is set to Y, the verification module 270 may perform retraining by executing operation S221. In addition, the verification module 270 checks whether the process is to be stopped when the allowable error of the deposition thickness is 5 times or more and 0.3 nm or more. Referring to Table 3, in the case of the deposition thickness, since the process stop is set to Y, the verification module 270 performs operation S217. In operation S217, the verification module 270 stops the process and may perform operation S219. In operation S219, since the retraining of the deposition thickness is set to Y, the verification module 270 may perform retraining by executing operation S221. On the contrary, when the retraining of the deposition thickness is set to N in operation S219, the verification module 270 may perform operation S223.

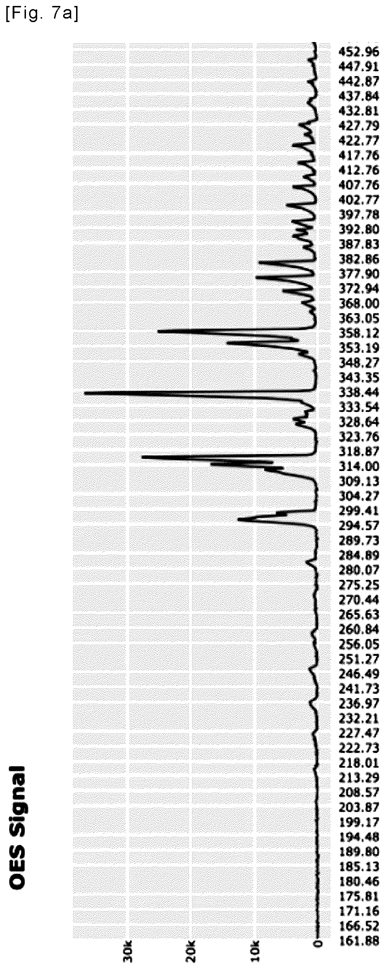

Next, in operation S223, the visualization module 280 performs a visualization function using the collected sensing data, prediction data, and training results in a manner such as a graph. This will be described with reference to FIGS. 7A to 7F. FIGS. 7A to 7F are screen examples illustrating visualization data of operation results for monitoring a plasma state and a plasma process state according to an embodiment of the present disclosure.

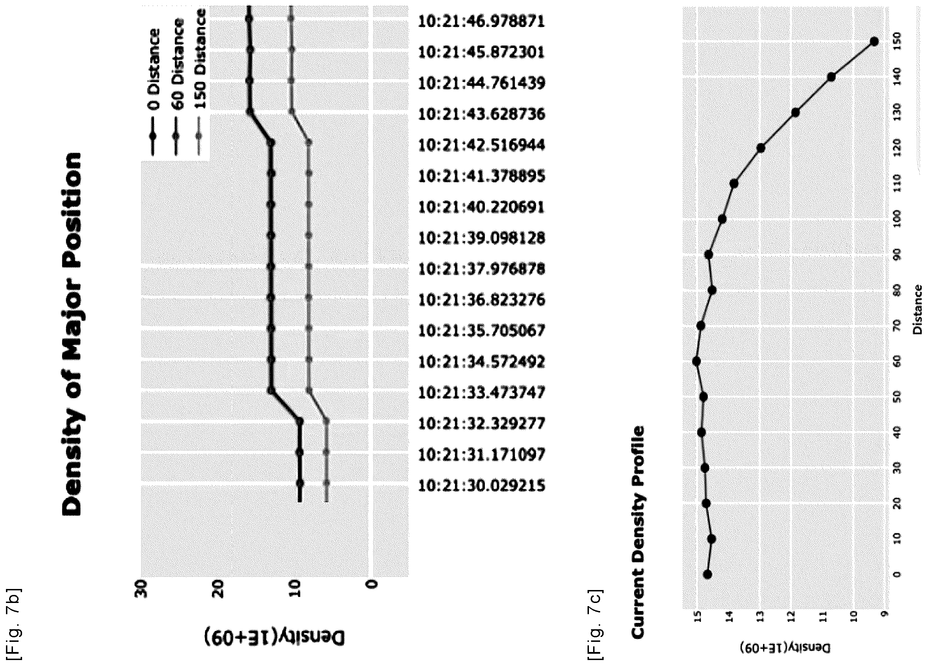

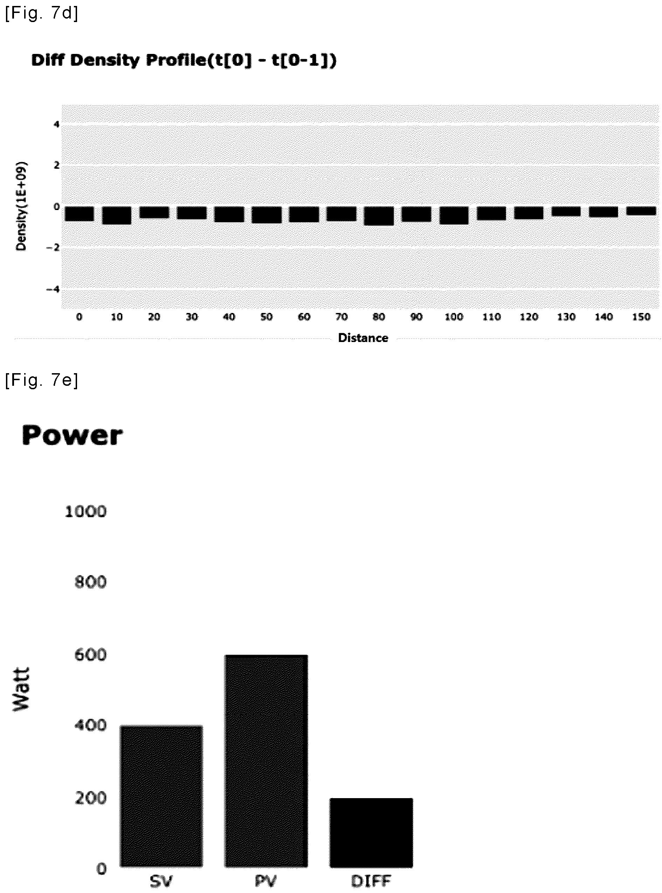

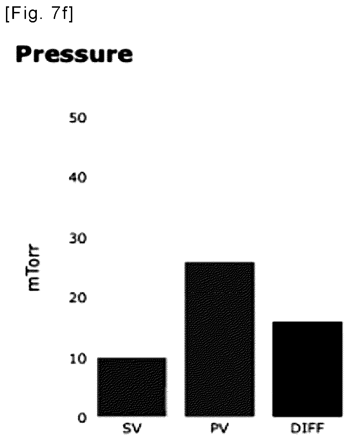

FIG. 7A illustrates OES sensing data obtained from an OES sensor at a current time, FIG. 7B illustrates a time accumulation graph of electron density data for a specific region of a plasma chamber predicted by the OES sensing data, FIG. 7C illustrates a graph showing electron density of all chamber regions at a current time, FIG. 7D illustrates a graph showing differences between electron density of all chamber regions predicted at a previous time and electron density of all chamber regions predicted at the current time, FIG. 7E illustrates a graph showing a set power value in a plasma chamber, a predicted power value, and a difference between the set power value and the predicted power value, and FIG. 7F illustrates a graph showing a set pressure value in a plasma chamber, a predicted pressure value, and a difference between the set pressure value and the predicted pressure value.

The embodiments of the present disclosure disclosed in the specification and the drawings are merely provided as specific examples to easily describe the technical content of the present disclosure and to help understand the present disclosure and are not intended to limit the scope of the present disclosure. Accordingly, the scope of the present disclosure should be interpreted as including all changes or modified forms derived based on the technical idea of the present disclosure in addition to the embodiments disclosed herein.

## Claims

1. A monitoring method comprising:
collecting, using an electronic device, sensing data corresponding to a preset collection condition among sensing data acquired from a plurality of sensors;
simultaneously storing and preprocessing, using the electronic device, the sensing data;
selecting, using the electronic device, input data for training and training with the selected input data; and
predicting, using the electronic device, a plasma state and a plasma process state based on the training data derived through the training.

2. The monitoring method of claim 1, further comprising:
after predicting a plasma state and a plasma process state,
verifying, using the electronic device, the prediction result; and
determining, using the electronic device, whether to stop the plasma process or whether to retrain the sensing data based on the verification result.

3. The monitoring method of claim 2, further comprising:
displaying, using the electronic device, at least one of the prediction result and the verification result.

4. The monitoring method of claim 1, wherein collecting sensing data includes:
identifying a collection condition including a name and a unique address of at least one sensor among the plurality of sensors, a number of times for collection failure of the sensing data, and a message name set for the sensing data.

5. The monitoring method of claim 4, wherein collecting sensing data includes:
transmitting a request signal for the sensing data to the at least one sensor in a predetermined period or in real time; and
collecting the sensing data from the at least one sensor based on the request signal.

6. The monitoring method of claim 5, wherein collecting sensing data includes:
loading the sensing data into at least one message queue corresponding to the at least one sensor when the collection of the sensing data is completed; and
confirming the completion of the collection of the sensing data when loading the sensing data is identified to be completed.

7. The monitoring method of claim 6, wherein simultaneous preprocessing includes:
identifying a preprocessing setting information corresponding to the at least one sensor; and
preprocessing the sensing data based on the preprocessing setting information.

8. The monitoring method of claim 7, wherein training includes:
setting a prediction interval for training;
selecting sensing data included in the prediction interval among the sensing data loaded into the message queue;
performing statistical processing of the selected sensing data; and
selecting the input data for training through a regression analysis of the sensing data.

9. A monitoring apparatus comprising:
a collection module configured to collect sensing data corresponding to a preset collection condition among sensing data related to a plasma process acquired from a plurality of sensors;
a data storage module configured to receive and store the sensing data from the collection module;
a preprocessing module configured to receive and preprocess the sensing data from the collection module;
a training execution module configured to select input data for training among the sensing data preprocessed by the preprocessing module and to train with the selected input data; and
a prediction module configured to predict a plasma state and a plasma process state based on the training data derived through the training,
wherein the collection module is configured to simultaneously transmit the sensing data to both the data storage module and the preprocessing module.

10. The monitoring apparatus of claim 9, further comprising:
a verification module configured:
to verify the prediction result predicted by the prediction module and
to determine, based on the verification result, whether to stop the plasma process or whether to retrain the sensing data.

11. The monitoring apparatus of claim 10, further comprising:
a visualization module configured to display at least one of the prediction result and the verification result.

12. The monitoring apparatus of claim 11, wherein the collection module is configured to identify the collection condition including a name and a unique address of at least one sensor among the plurality of sensors, a number of times for collection failure of the sensing data, and a message name set for the sensing data.

13. The monitoring apparatus of claim 12, wherein the collection module is configured:
to transmit a request signal for the sensing data to the at least one sensor in a predetermined period or in real time, and
to collect the sensing data from the at least one sensor based on the request signal.

14. The monitoring apparatus of claim 13, wherein the collection module is configured to load the sensing data into at least one message queue corresponding to the at least one sensor when the collection of the sensing data is completed.

15. The monitoring apparatus of claim 14, wherein the preprocessing module is configured:
to identify preprocessing setting information corresponding to the at least one sensor, and
to preprocess the sensing data based on the preprocessing setting information.

16. The monitoring apparatus of claim 15, wherein the training execution module is configured:
to set a prediction interval for training,
to select sensing data included in the prediction interval among the sensing data loaded into the message queue, and
to select the input data for the training through a statistical processing and a regression analysis of the sensing data.
